(19) Europäisches Patentamt
European Patent Office
Office européen des brevets

(11) **EP 1 983 362 A1**

(12) **EUROPEAN PATENT APPLICATION**
published in accordance with Art. 158(3) EPC

(43) Date of publication:
**22.10.2008 Bulletin 2008/43**

(51) Int Cl.:
**G02B 17/08** (2006.01)    **G03F 7/20** (2006.01)
**H01L 21/027** (2006.01)

(21) Application number: **07713756.0**

(22) Date of filing: **31.01.2007**

(86) International application number:
**PCT/JP2007/051596**

(87) International publication number:
**WO 2007/091463 (16.08.2007 Gazette 2007/33)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **07.02.2006 JP 2006029244**

(71) Applicant: **Nikon Corporation Tokyo 100-8331 (JP)**

(72) Inventor: **OMURA, Yasuhiro Tokyo 100-8331 (JP)**

(74) Representative: **HOFFMANN EITLE Patent- und Rechtsanwälte Arabellastrasse 4 81925 München (DE)**

(54) **CATADIOPTRIC IMAGING SYSTEM, EXPOSURE DEVICE, AND DEVICE MANUFACTURING METHOD**

(57)    A catadioptric imaging optical system with a high numerical aperture and including an effective imaging region shaped optimally for use in a batch type exposure apparatus and having an imaging magnification with a small absolute value. The catadioptric imaging optical system includes a dioptric first imaging system (G1), which forms a first intermediate image based on light from the first plane (R), a second imaging system (G2), which forms a second intermediate image based on light from the first intermediate image and includes a concave reflection mirror (CM), a third dioptric imaging system (G3), which forms a reduced image on the second plane based on light from the second intermediate image, and a deflecting mirror (M1, M2) arranged in an optical path extending from the first imaging system to the second imaging system and an optical path extending from the second imaging system to the third imaging system. The first imaging system and the second imaging system provide a composite imaging magnification having an absolute value β12 of less than 0.55, and the third imaging system has an imaging magnification with an absolute value β3 of less than 0.35.

**Fig.4**

**Description**

TECHNICAL FIELD

The present invention relates to catadioptric imaging optical system, an exposure apparatus, and a device manufacturing method, and more particularly, to a projection optical system optimal for use in an exposure apparatus employed for manufacturing a micro-device such as a semiconductor device and a liquid crystal display device in a photolithography process.

BACKGROUND ART

In a photolithography process for manufacturing a semiconductor device or the like, an exposure apparatus is used to project and expose a pattern image of a mask (or reticle) on a photosensitive substrate (wafer, glass plate, or the like that is coated with photoresist) with a projection optical system. In an exposure apparatus, the projection optical system is required to have a higher resolving power (resolution) since integration of semiconductor devices and the like has become higher. The wavelength $\lambda$ of the illumination light (exposure light) must be shortened and the image side numerical aperture NA of the projection optical system must be enlarged to satisfy the requirements for the resolving power (resolution) of the projection optical system. Accordingly, a liquid immersion technique is known to increase the image side numerical aperture by filling an optical path between the projection optical system and the photosensitive substrate with a medium such as a liquid having a high refractive index.

Generally, in a projection optical system having a large image side numerical aperture, the employment of a catadioptric imaging optical system is desirable from the viewpoint in which the Petzval condition can be satisfied and flatness of an image can be obtained even in a dry system without being limited to the liquid immersion system. Further, the employment of an off-axis field imaging optical system in which an effective field (ultimately, an effective imaging region) does not include an optical axis is desirable from the viewpoint in which it can be applied to any fine pattern. In the prior art, various off-axis field catadioptric imaging optical system optimal for use in an exposure apparatus have been proposed (for example, refer to patent document 1).
Patent Document 1: Japanese Laid-Open Patent Publication No. 8-62502

SUMMARY OF THE INVENTION

Mask patterns have been continuously miniaturized in exposure apparatuses due to the miniaturization of semiconductor circuits. However, the miniaturization of mask patterns has increased the mask cost. When using a single mask for each of various types of semiconductors that are manufactured in small quantities, the chip cost would be increased. Therefore, to miniaturize a semiconductor circuit without miniaturizing a mask pattern, the absolute value of a projection magnification (imaging magnification) for a projection optical system may be set to a small value. However, in a scanning type exposure apparatus, which scans and exposes a pattern onto a single shot region while moving a mask and photosensitive substrate relative to a projection optical system, when the magnification of the projection optical system is set to a small absolute value, the throughput would be lowered due to the response speed of a mask stage used for scanning the mask.

In a batch type exposure apparatus that performs batch exposure of a mask pattern onto a single shot region on a photosensitive substrate, the throughput would not be decreased even when setting the projection magnification of a projection optical system to a small absolute value. However, in a conventional off-axis field catadioptric imaging optical system such as that disclosed in patent document 1, the optical path of light reflected by a reflection mirror is separated from the optical path of light incident on the reflection mirror. Thus, only a relatively long rectangular or arcuate effective imaging region (effective projection region) can be obtained. Thus, even when the magnification can be set to a small absolute value for a scanning type exposure apparatus, this would be practically impossible for a batch type exposure apparatus.

Accordingly, it is an object of the present invention to provide a catadioptric imaging optical system with a high numerical aperture including an effective imaging region shaped optimally for use in, for example, a batch type exposure apparatus and having an imaging magnification with a small absolute value. A further object of the present invention is to provide an exposure apparatus that projects and exposes a fine pattern with high accuracy and high throughput by employing a catadioptric imaging optical system with a high numerical aperture including an effective imaging region shaped optimally for use in a batch type exposure apparatus and having an imaging magnification with a small absolute value.

To achieve the above object, a first embodiment of the present invention provides a catadioptric imaging optical system that forms a reduced image of a first plane on a second plane. The catadioptric imaging optical system includes a first imaging system including only refractive optical elements and which forms a first intermediate image based on light from the first plane. A second imaging system includes at least one concave reflection mirror and forms a second intermediate image based on light from the first intermediate image. A third imaging system includes only refractive optical elements and forms the reduced image of the first plane on the second plane based on light from the second intermediate image. At least one deflecting mirror is arranged in at least either one of an optical path extending from the first imaging system to the second imaging system and an optical path extending from the second imaging system to the third imaging system. The first imaging system and the second imaging system provide a composite imaging magnification having an absolute value $\beta12$ of less than 0.55, and the third imaging system has an imaging magnification with an absolute value $\beta3$ of less than 0.35.

A second embodiment of the present invention provides a catadioptric imaging optical system that forms a reduced image of a first plane on a second plane. The catadioptric imaging optical system includes a dioptric first imaging system arranged in an optical path between the first plane and the second plane, with the first imaging system forming a first conjugation position optically conjugated with the first plane. A second imaging system is arranged in an optical path between the first imaging system and the second plane and includes at least one concave reflection mirror, with the second imaging system forming a second conjugation position optically conjugated with the first conjugation position. A dioptric third imaging system is arranged in an optical path between the second imaging system and the second plane, with the second imaging system forming a third conjugation position optically conjugated with the second conjugation position. At least one deflecting mirror is arranged in at least either one of an optical path extending between the first imaging system and the second imaging system and an optical path extending between the second imaging system and the third imaging system. The first imaging system and the second imaging system provide a composite imaging magnification having an absolute value $\beta12$ of less than 0.55, and the third imaging system has an imaging magnification with an absolute value $\beta3$ of less than 0.35.

A third embodiment of the present invention provides an exposure apparatus including the catadioptric imaging optical system of the first embodiment or the second embodiment which forms an image of a predetermined pattern on a photosensitive substrate set on the second plane based on light from the pattern, which is set on the first plane.

A fourth embodiment of the present invention provides an exposure apparatus including a catadioptric imaging optical system that projects an image of a predetermined pattern set on a first plane onto a second plane based on light from the predetermined pattern. A substrate stage holds a photosensitive substrate positioned at the second plane. A control unit controls movement of the substrate stage. The catadioptric imaging optical system includes at least one deflecting mirror and forms a position optically conjugated with the first plane in an optical path between the first plane and the second plane. The control unit controls the substrate stage in a static state when the image of the pattern is transferred to the photosensitive substrate.

A fifth embodiment of the present invention provides a device manufacturing method including exposing the predetermined pattern onto the photosensitive substrate using the exposure apparatus of the third embodiment of fourth embodiment, developing the photosensitive substrate onto which the pattern has been transferred to form a mask layer shaped in correspondence with the pattern on a surface of the photosensitive substrate, and processing the surface of the photosensitive substrate through the mask layer.

In the present invention, for a thrice imaging type catadioptric imaging optical system, the composite imaging magnification of a dioptric first imaging system and a second imaging system including a concave reflection mirror has an absolute value $\beta12$ of less than 0.55. Further, the imaging magnification of a dioptric third imaging system has an absolute value $\beta3$ of less than 0.35. As a result, the imaging magnification of the entire imaging optical system may have an absolute value $\beta$ that is reduced to, for example, about one-eighth. Further, enlargement of a deflecting mirror, which separates the optical path of light incident to the concave reflection mirror in the second imaging system from the optical path of light reflected by the concave reflection mirror, can be prevented, while obtaining a relatively large effective imaging region, which has a rectangular form that is close to a square (i.e., shape that is optimal for use in a batch type exposure apparatus).

In this manner, the present invention provides a catadioptric imaging optical system with a high numerical aperture including an effective imaging region shaped optimally for use in, for example, a batch type exposure apparatus and having an imaging magnification with a small absolute value. Further, the present invention provides an exposure apparatus that projects and exposes a fine pattern with high accuracy and high throughput by employing a catadioptric imaging optical system with a high numerical aperture including an effective imaging region shaped optimally for use in a batch type exposure apparatus and having an imaging magnification with a small absolute value. This ultimately enables satisfactory devices to be manufactured with high accuracy and high throughput.

BRIEF DESCRIPTION OF THE DRAWINGS

Fig. 1 is a schematic diagram showing the structure of an exposure apparatus according to a preferred embodiment of the present invention:

Fig. 2 is a diagram showing the positional relationship of an exposure region formed on a wafer and a reference optical axis;

Fig. 3 is a schematic diagram showing the structure between a boundary lens and a wafer;

Fig. 4 is a diagram showing the lens structure in an projection optical system of a first example;

Fig. 5 is a chart showing transverse aberration in a projection optical system of the first example;

Fig. 6 is a diagram showing the lens structure in an projection optical system of a second example;

Fig. 7 is a chart showing transverse aberration in a projection optical system of the second example;

Fig. 8 is a schematic diagram showing the structure of a catadioptric imaging optical system in a first modification;

Fig. 9 is a schematic diagram showing the structure of a catadioptric imaging optical system in a second modification;

Fig. 10 is a flowchart showing the procedures for obtaining a semiconductor device; and

Fig. 11 is a flowchart showing the procedures for obtaining a liquid crystal display device.

DESCRIPTION OF REFERENCE NUMBERS

**[0015]**

| R | reticle |
|---|---|
| PL | projection optical system |
| Lb | boundary lens |
| Lp | plane-parallel plate |
| Lm, Lm1, Lm2 | pure water (liquid) |
| W | wafer |
| 1 | illumination optical system |
| 14 | illumination optical system |

BEST MODE FOR CARRYING OUT THE INVENTION

A catadioptric imaging optical system of the present invention includes a dioptric first imaging system which forms a first intermediate image based on light from a first plane (object plane). A second imaging system includes a concave reflection mirror and forms a second intermediate image based on light from the first intermediate image. A dioptric third imaging system forms a reduced image on a second plane based on light from the second intermediate image. At least one deflecting mirror is arranged in at least either one of an optical path extending from the first imaging system to the second imaging system and an optical path extending from the second imaging system to the third imaging system. The first imaging system and the second imaging system provide a composite imaging magnification having an absolute value $\beta12$ of less than 0.55, and the third imaging system has an imaging magnification with an absolute value $\beta3$ of less than 0.35.

By setting the composite imaging magnification of the first imaging system and the second imaging system to have an absolute value $\beta12$ of less than 0.55, even when setting the absolute value $\beta$ of the imaging magnification for the entire imaging optical system to be small at, for example, one-eighth, a deflecting mirror for separating an optical path of light incident to the concave reflection mirror of the second imaging system from an optical path of reflection light from the concave reflection mirror may be prevented from being enlarged. At the same time, an effective imaging region that is relatively large and has a rectangular shape that is close to a square (i.e., shape optimal for use in a batch type exposure apparatus) can be obtained. By avoiding enlargement of the deflecting mirror, and ultimately, the entire optical system, aberrations related to the image height, such as field curvature, astigmatism, coma aberration, and distortion, may be corrected in a satisfactory manner. To exhibit the effects of the present invention is a further satisfactory manner, it is preferable that $\beta12$ be set to be greater than 0.4. This restricts the angular range of the light incident to the deflecting mirror, enables reflection film designing of which reflectivity and phase difference is corrected in a satisfactory manner, and enables satisfactory imaging performance to be maintained.

Further, by setting the imaging magnification of the third imaging system to have an absolute value of less than 0.35, the absolute value $\beta$ of the imaging magnification for the entire imaging optical system can be set to be small, for example, about one-eighth. As a result, even when the line width of a mask pattern is not narrowed for miniaturization, miniaturization of, for example, a semiconductor circuit is possible. This reduces mask costs. To exhibit the effects of the present invention in a further satisfactory manner, it is preferable that $\beta3$ be set to be greater than 0.15 and less than 0.30. This shortens the distance (off-axial distance) between the optical axis of the imaging optical system and the effective imaging region, while preventing enlargement of the deflecting mirror, which separates optical paths. As a result, enlargement of the entire optical system can be prevented. In this manner, the present invention provides a catadioptric imaging optical system with a high numerical aperture including an effective imaging region shaped optimally for use in, for example, a batch type exposure apparatus and having an imaging magnification with a small absolute value.

Further, in the catadioptric imaging optical system of the present invention, it is preferable that a first deflecting mirror be arranged in an optical path extending from the first imaging system to the second imaging system and that a second deflecting mirror be arranged in an optical path extending from the second imaging system to the third imaging system. This enables the optical axis of the first imaging system and the optical axis of the third imaging system to be set as a common optical axis. Especially, the optical axes of three imaging systems and he reflection surfaces of two deflecting mirrors can be positioned in relation with a single reference point. This increases stability of the optical system and facilitates optical adjustments and mechanical designing. Further, by setting the optical axis of the second imaging system to be perpendicular to the optical axis of the third imaging system, optical adjustment with higher accuracy is facilitated. This achieves higher stability of the optical system.

In the catadioptric imaging optical system of the present invention, it is preferable that the imaging magnification of the first imaging system have an absolute value $\beta 1$ of less than 0.55. This enables the first deflecting mirror to be reduced in size and enables the absolute value $\beta$ of the imaging magnification for the entire imaging optical system to be set to be small, for example, about one-eighth. As described above, the composite imaging magnification of the first imaging system and the second imaging system is set to have an absolute value $\beta 12$ that is smaller than 0.55. This enables reduction in the size of the second deflecting mirror.

In the catadioptric imaging optical system of the present invention, it is preferable that an optical path between the catadioptric imaging optical system and the image plane be filled with liquid having a refractive index that is greater than 1.3. The employment of such a liquid immersion type optical system having a liquid immersion region formed at the image side obtains a large effective image side numerical aperture while obtaining a relatively large effective imaging region. Further, obtain a catadioptric imaging optical system optimal for use in, for example, a batch type exposure apparatus, it is preferable that a rectangular effective imaging region be formed so that the ratio of the length of the short side to the length of the long side is 0.5 or greater. It is further preferable that this ratio be 0.67 or greater.

Further, in the catadioptric imaging optical system of the present invention, it is preferable that a first intermediate image be formed in an optical path extending from the first deflecting mirror to the concave reflection mirror and that a second intermediate image be formed in an optical path extending from the concave reflection mirror to the second deflecting mirror. This facilitates separation of the optical path of the light incident to the concave reflection mirror from the optical path of the reflection light from the concave reflection mirror in the second imaging system.

As described above, the deflecting mirror functions to separate optical paths. However, the formation position of an intermediate image must be somewhat close to the deflecting mirror in order to shorten the distance between the optical axis and the effective imaging region (off-axial distance) and minimize the maximum image height. However, batch exposure differs from scan exposure in that when a deflecting mirror is located near or at the formation position of an intermediate image, a small defect (e.g., defect having a diameter of 100 $\mu$m or smaller) may be transferred to an image plane.

Therefore, in the present invention, it is preferable that a first deflecting mirror is arranged in the optical path extending from the first imaging system to the second imaging system and that condition (1) be satisfied. In the same manner, it is preferable that a first deflecting mirror is arranged in the optical path extending from the second imaging system to the third imaging system and that condition (2) is satisfied. In condition (1), d1 represents the distance between a paraxial image plane position of the first intermediate image and an intersecting point of an optical axis with a reflection surface of the first deflecting mirror or an extension of the reflection surface. In condition (2), d2 represents the distance between a paraxial image plane position of the first intermediate image and an intersecting point of an optical axis with a reflection surface of the first deflecting mirror or an extension of the reflection surface. Further, in conditions (1) and (2), h represents the maximum image height.

$$1.4 < d1 < h \qquad (1)$$

$$1.4 < d2 < h \qquad (2)$$

When exceeding the lower limit value in conditions (1) and (2), the distance d1 between the formation position of the first intermediate image and the first deflecting mirror and the distance d2 between the formation position of the second intermediate image and the second deflecting mirror become too small. This is not desirable since a small defect on the first deflecting mirror or the second deflecting mirror would easily be transferred to the image plane. It is preferable that the upper limit values of conditions (1) and (2) be set to 4. It would be further preferable if the upper limit values were to be set to 3. When exceeding the upper limit value, the distance between the optical axis and the effective imaging region (off-axial distance) for optical path separation would have to be increased. This would not be desirable since the maximum image height would increase and enlarge the optical system. Furthermore, aberrations related to the image height, such as field curvature, astigmatism, coma aberration, and distortion, would be adversely affected.

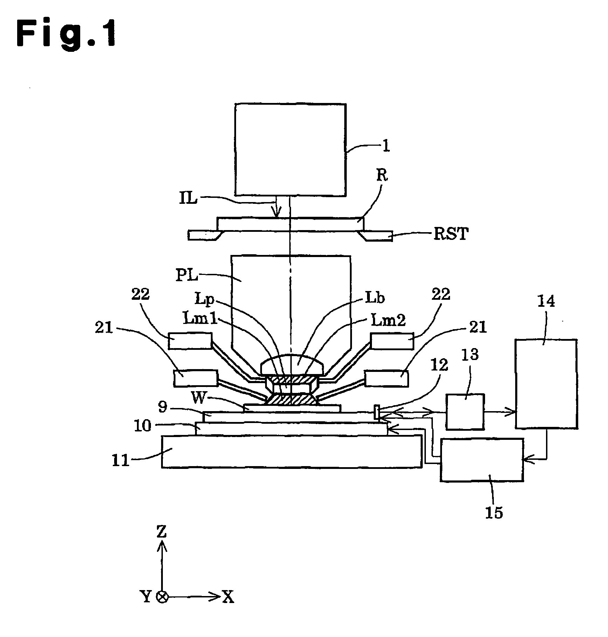

One embodiment of the present invention will now be described with reference to the accompanying drawings. Fig. 1 is a schematic diagram showing the structure of an exposure apparatus according to one embodiment of the present invention. In Fig. 1, the X axis and Y axis are set in directions parallel to a wafer W, and the Z axis is set in a direction orthogonal to the wafer W. More specifically, an XY plane is set parallel to a horizontal plane, and the +Z axis is set to extend upward along a vertical direction.

As shown in Fig. 1, the exposure apparatus of the present embodiment incorporates an illumination optical system 1 including, for example, an ArF excimer laser light source, which is an exposure light source, and is formed by an optical integrator (homogenizer), a field stop, a condenser lens, and the like. Exposure light (exposure beam) IL, which includes ultraviolet pulse light having a wavelength of 193 nm and which is emitted from the light source, passes through the illumination optical system 1 and illuminates a reticle (mask) R. In the reticle R, a pattern that is to be transferred is formed, and a rectangular pattern region having a long side extending along the X direction and a short side extending along the Y direction is illuminated.

The light passing through the reticle R forms a reticle pattern with a predetermined reduction projection magnification on the exposure region (shot region) of the wafer (photosensitive substrate) W, which is coated by a photoresist, through a projection optical system PL, which is a liquid immersion catadioptric imaging optical system. That is, a pattern image is formed in a rectangular static exposure region having a long side extending along the X direction and a short side extending along the Y direction of the wafer W in optical correspondence with the rectangular illumination region on the reticle R.

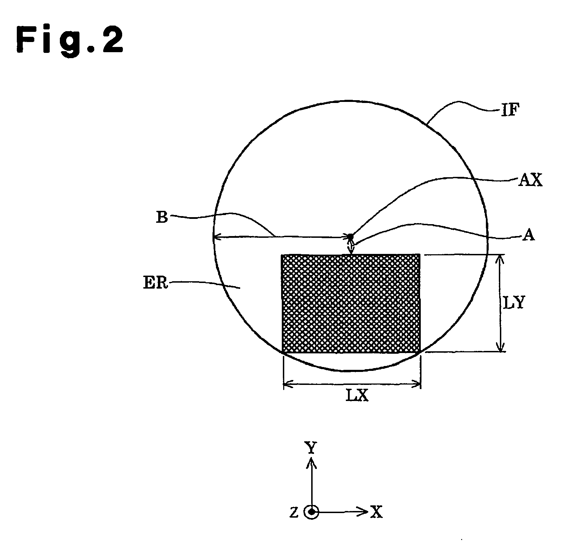

Fig. 2 is a diagram showing the positional relationship of the rectangular exposure region formed on a wafer and an optical axis in the present embodiment. In the present embodiment, referring to Fig. 2, a rectangular exposure region ER is set in a circular region (image circle) IF having a radius B and a center coinciding with a reference optical axis AX. The exposure region ER has a predetermined size and is spaced from the optical axis AX in the Y direction by an off-axial distance A. The length in the X direction of the exposure region ER is LX, and the length in the Y direction is LY. Therefore, although not shown in the drawings, a rectangular illumination region having a size and a shape corresponding to the exposure region ER is formed on the reticle R at a position spaced apart from the optical axis AX in the Y direction by a distance corresponding to the off-axial distance A in correspondence with the rectangular exposure region ER.

The reticle R is held parallel to the XY plane on a reticle stage RST, and a mechanism for finely moving the reticle R in the X direction, the Y direction, and a rotation direction is incorporated in the reticle stage RST. A reticle laser interferometer (not shown) measures and controls in real time the position of the reticle stage RST in the X direction, the Y direction, and the rotation direction. The wafer W is fixed parallel to the XY plane on a Z stage 9 by a wafer holder (not shown). The Z stage 9, which is fixed on an XY stage 10 that moves along the XY plane substantially parallel to an image plane of the projection optical system PL, controls a focus position (position in Z direction) and inclination angle of the wafer W.

A wafer laser interferometer 13, which uses a movable mirror 12 arranged on the Z stage 9, measures and controls in real time the position of the Z stage 9 in the X direction, the Y direction, and the rotation direction. Further, the XY stage 10 is mounted on a base 11 and controls the X direction, the Y direction, and the rotation direction of the wafer W. A main control system 14 arranged in the exposure apparatus of the present embodiment adjusts the position of the reticle R in the X direction, the Y direction, and the rotation direction based on the measurement of a reticle laser interferometer. In other words, the main control system 14 transmits a control signal to a mechanism incorporated in the reticle stage RST and adjusts the position of the reticle R by finely moving the reticle stage RST.

The main control system 14 also adjusts the focus position (position in Z direction) and the inclination angle of the wafer W to align the surface of the wafer W with the image plane of the projection optical system PL by using an automatic focusing technique and an automatic leveling technique. That is, the main control system 14 transmits a control signal to a wafer stage drive system 15 and adjusts the focus position and the inclination angle of the wafer W by driving the Z stage 9 with the wafer stage drive system 15. Furthermore, the main control system 14 adjusts the position of the wafer W in the X direction, the Y direction, and the rotation direction based on a measurement of the wafer laser interferometer 13. In other words, the main control system 14 transmits a control signal to the wafer stage drive system 15 and performs position adjustment in the X direction, the Y direction, and the rotation direction of the wafer W by driving the XY stage 10 with the wafer stage drive system 15.

During exposure, the pattern image on the reticle R is projected and exposed onto an entire predetermined shot region on the wafer W. Subsequently, the main control system 14 transmits a control signal to the wafer stage drive system 15 and drives the XY stage 10 with the wafer stage drive system 15 to step-move another shot region on the wafer W to the exposure position. In this manner, the step-and-repeat technique repeats operations for performing batch exposure on the wafer W with the pattern image of the reticle R.

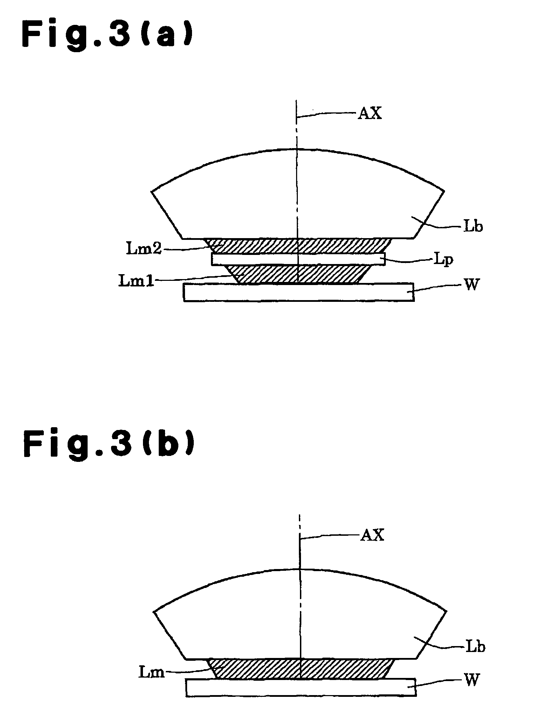

Fig. 3 is a schematic diagram showing the structure between a boundary lens and a wafer in the present embodiment. In a projection optical system PL according to a second example of the present embodiment, as shown in Fig. 3(a), a plane-parallel plate Lp arranged closest to the wafer includes a surface facing toward the reticle R (object side) and contacting a second liquid Lm2 and a surface facing toward the wafer W and contacting a first liquid Lm1. A boundary lens Lb arranged next to the plane-parallel plate Lp includes a surface facing toward the reticle R and contacting gas and a surface facing toward the wafer W and contacting the second liquid Lm2. In a projection optical system PL according to a first example of the present embodiment, an optical path between the boundary lens Lb and the wafer W is filled with a liquid Lm. In the present embodiment, pure water (demineralized water), which can easily be obtained in mass amounts in a semiconductor production plant or the like, is used as the liquid (Lm1, Lm2, Lm).

To continuously fill the optical path between the boundary lens Lb of the projection optical system PL and wafer W or the optical path between the plane-parallel plate Lp and wafer W with liquid (Lm1, Lm2, Lm), the technique described in, for example, International Patent Publication No. WO99/49504 or Japanese Laid-Open Patent Publication No. 10-303114 may be used. In a second example, as shown in Fig. 1, the first liquid Lm1 is circulated in the optical path between the plane-parallel plate Lp and the wafer W using a first water supply/discharge mechanism 21. Further, the second liquid Lm2 is circulated in the optical path between the boundary lens Lb and the plane-parallel plate Lp using a second water supply/discharge mechanism 22. In this manner, the circulation of a small amount of liquid serving as immersion liquid prevents corrosion and the generation of mold thereby preventing decomposition of the liquid. In the first example, a single water supply/discharge mechanism (not shown) is used to circulate the liquid Lm in the optical path between the boundary lens Lb and the wafer W.

In each example of the present embodiment, the aspheric surface is expressed by the following equation (a), where y represents the height in a direction perpendicular to the optical axis, z represents the distance (sag amount) along the optical axis from a tangent plane at a vertex of a aspheric surface to a position on the aspheric surface at height y, r represents a vertex curvature radius, $\kappa$ represents a conical coefficient, and $C_n$ represents an n order aspheric surface coefficient. In the (1) to (4), which will be described later, a * mark is added to the right side of a surface number for an optical surface having an aspherical shape.

$$z = (y^2/r) \, / \, [1 + \{1 - (1 + \kappa) \cdot y^2/r^2\}^{1/2}] + C_4 \cdot y^4 + C_6 \cdot y^6$$
$$+ \, C_8 \cdot y^8 + C_{10} \cdot y^{10} + C_{12} \cdot y^{12} + C_{14} \cdot y^{14} + C_{16} \cdot y^{16} \qquad (a)$$

In each example of the present embodiment, the projection optical system PL includes a first imaging system G1, a second imaging system G2, and a third imaging system G3. The first imaging system G1 forms a first intermediate image of a pattern of the reticle R arranged on an object plane (first plane). The second imaging system G2 forms a second intermediate image of the reticle pattern (image of the first intermediate image, and secondary image of the reticle pattern) based on the light from the first intermediate image. The third imaging system G3 forms a final image (reduced image of the reticle pattern) of the reticle pattern on the wafer W arranged on the image plane (second plane) based on the light from the second intermediate image. The first imaging system G1 and the third imaging system G3 are both dioptric systems, and the second imaging system G2 is a catadioptric system including concave reflection mirrors.

A first planar reflection mirror (first deflecting mirror) M1 is arranged in an optical path between the first imaging system G1 and the second imaging system G2. A second planar reflection mirror (second deflecting mirror) M2 is arranged in an optical path between the second imaging system G2 and the third imaging system G3. Therefore, in the projection optical system PL of each example, light from the reticle R passes through the first imaging system G1 and forms the first intermediate image of the reticle pattern near the first planar reflection mirror M1 in the optical path between the first planar reflection mirror M1 and the second imaging system G2. Then, the light from the first intermediate image passes through the second imaging system G2 and forms the second intermediate image of the reticle pattern near the second planar reflection mirror M2 in the optical path between the second planar reflection mirror M2 and the second imaging system G2. Further, the light from the second intermediate image passes through the third imaging system G3 and forms the final image of the reticle pattern on the wafer W.

Additionally, in the projection optical system PL of each example, the first imaging system G1 and the third imaging system G3 respectively have an optical axis AX1 and an optical axis AX3, which extend straight in the vertical direction. The optical axis AX1 and the optical axis AX3 coincide with a reference optical axis AX. The second imaging system G2 has an optical axis AX2 extending straight in the horizontal direction (orthogonal to the reference optical axis AX). Therefore, all of the optical members in the first imaging system G1 and all of the optical members in the third imaging system G3 are arranged parallel to a plane perpendicular to the gravitational direction, that is, parallel to a horizontal plane. Further, the first planar reflection mirror M1 and the second planar reflection mirror M2 each have a reflection surface set at an angle of 45 degrees relative to the reticle surface. The first planar reflection mirror M1 and the second planar reflection mirror M2 are formed integrally as a single optical member. Further, in each example, the projection optical system PL is configured to be substantially telecentric to both the object side and the image side.

[First Example]

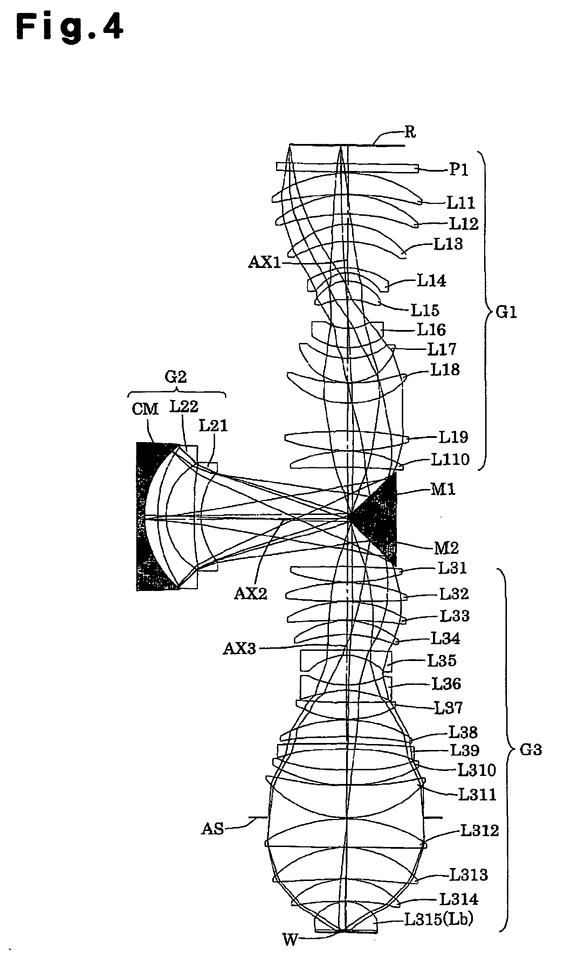

Fig. 4 is a diagram showing a lens structure of a projection optical system according to a first example of the present embodiment. Referring to Fig. 4, in the projection optical system PL of the first example, the first imaging system G1 includes, sequentially from the reticle side, a plane-parallel plate P1, a positive meniscus lens L11 having a convex surface facing toward the reticle side, a positive meniscus lens L12 having a convex surface facing toward the reticle side, a positive meniscus lens L13 having a convex surface facing toward the reticle side, a negative meniscus lens L14 having an aspherical convex surface facing toward the reticle side, a positive meniscus lens L15 having a convex surface facing toward the reticle side, a negative meniscus lens L16 having a concave surface facing toward the reticle side, a positive meniscus lens L17 having an aspherical concave surface facing toward the reticle side, a positive meniscus lens L18 having a concave surface facing toward the reticle side, a biconvex lens L19, and a positive meniscus lens L110 having an aspherical concave surface facing toward the wafer side.

Further, the second imaging system G2 includes, along the approach path of light sequentially from the incidence side of light, a negative meniscus lens L21 having a concave surface facing toward the incidence side, a negative meniscus lens L22 having a concave surface facing toward the incidence side, and a concave reflection mirror CM having a concave surface facing toward the incidence side. The third imaging system G3 includes, sequentially from the reticle side (i.e., incidence side of light), a biconvex lens L31, a biconvex lens L32, a positive meniscus lens L33 having a convex surface facing toward the reticle side, a positive meniscus lens L34 having an aspherical concave surface facing toward the wafer side, a negative meniscus lens L35 having a convex surface facing toward the reticle side, a biconcave lens L36 having an aspherical concave surface facing toward the wafer side, a positive meniscus lens L37 having an aspherical concave surface facing toward the reticle side, a positive meniscus lens L38 having an aspherical concave surface facing toward the wafer side, a negative meniscus lens L39 having an aspherical concave surface facing toward the wafer side, a positive meniscus lens 310 having an aspherical concave surface facing toward the reticle side, a positive meniscus lens 311 having a concave surface facing toward the reticle side, a variable aperture stop AS for varying the numerical aperture of the projection optical system PL, a planoconvex lens L312 having a planar surface facing toward the wafer side, a positive meniscus lens L313 having an aspherical concave surface facing toward the wafer side, a positive meniscus lens L314 having an aspherical concave surface facing toward the wafer side, and a planoconvex lens L315 (boundary lens Lb) having a planar surface facing toward the wafer side.

In the first example, pure water (Lm) having a refractive index of 1.435876 with respect to the ArF excimer laser light (center wavelength λ = 193.306 nm), which is the used light (exposure light), fills the optical path between the boundary lens Lb and the wafer W. All light transmissive members including the boundary lens Lb are made of silica ($SiO_2$) having a refractive index of 1.5603261 with respect to the center wavelength of the used light.

Values for the data of the projection optical system PL in the first example are shown in table (1). In the main data of table (1), λ represents the center wavelength of the exposure light, β represents the level (absolute value) of the projection magnification (imaging magnification of the entire system), NA represents the image side (wafer side) numerical aperture, B represents the radius (maximum image height h) of the image circle IF of the wafer W, A represents the off-axial distance of the exposure region ER, LX represents the X direction dimension (dimension of long side) of the exposure region ER, and LY represents the Y direction dimension (dimension of short side) of the effective exposure region ER.

Furthermore, in the optical member data of table (1), the surface number represents the order of planes from the reticle side along a path in which light travels from the reticle surface, which is the object plane (first plane), to the wafer surface, which is the image plane (second plane), r represent the curvature radius of each plane (for an aspherical surface, vertex curvature radius: mm), d represents the on-axial interval of each surface, or the plane interval (mm), and n represents the refractive index with respect to the center wavelength. The sign added to the plane interval d is negative when in an optical path in which light advances from the concave reflection mirror CM to the second planar reflection mirror M2 and positive when in other optical paths. The notations in table (1) are the same in following table (2).

Table (1).

(Main Data)
λ=193.306nm, β=1/8, NA=1.3
B=17.2mm, A=2mm, LX=16.5mm, LY=13mm

(continued)

(Optical Member Data)

| Surface No. | r | d | n | Optical Member |
|---|---|---|---|---|
| | (reticle surface) | 40.0000 | | |
| 1 | ∞ | 16.0000 | 1.5603261 | (P1) |
| 2 | ∞ | 3.0000 | | |
| 3 | 248.01805 | 46.2710 | 1.5603261 | (L11) |
| 4 | 602.66085 | 1.0000 | | |
| 5 | 218.70999 | 40.9637 | 1.5603261 | (L12) |
| 6 | 380.72654 | 22.6799 | | |
| 7 | 149.99705 | 36.8390 | 1.5603261 | (L13) |
| 8 | 194.03000 | 57.9255 | | |
| 9* | 124.18781 | 11.4000 | 1.5603261 | (L14) |
| 10 | 78.33365 | 17.0857 | | |
| 11 | 75.24480 | 39.8976 | 1.5603261 | (L15) |
| 12 | 150.08406 | 63.1138 | | |
| 13 | -81.96667 | 40.2794 | 1.5603261 | (L16) |
| 14 | -128.53255 | 23.8848 | | |
| 15* | -128.30761 | 51.8483 | 1.5603261 | (L17) |
| 16 | -103.18116 | 1.0000 | | |
| 17 | -322.75337 | 45.2241 | 1.5603261 | (L18) |
| 18 | -162.41260 | 60.7932 | | |
| 19 | 805.57018 | 41.5384 | 1.5603261 | (L19) |
| 20 | -420.57151 | 1.0000 | | |
| 21 | 241.60229 | 37.0450 | 1.5603261 | (L110) |
| 22* | 3443.76334 | 110.0000 | | |
| 23 | ∞ | 304.7846 | | (M1) |
| 24 | -152.05268 | 15.0000 | 1.5603261 | (L21) |
| 25 | -664.05408 | 59.4385 | | |
| 26 | -132.36276 | 18.0000 | 1.5603261 | (L22) |
| 27 | -266.26977 | 27.2909 | | |
| 28 | -200.14029 | -27.2909 | | (CM) |
| 29 | -266.26976 | -18.0000 | 1.5603261 | (L22) |
| 30 | -132.36276 | -59.4385 | | |
| 31 | -664.05408 | -15.0000 | 1.5603261 | (L21) |
| 32 | -152.05268 | -303.7846 | | |
| 33 | ∞ | 105.0000 | | (M2) |
| 34 | 2764.61897 | 32.2302 | 1.5603261 | (L31) |
| 35 | -363.71712 | 1.0000 | | |
| 36 | 325.00179 | 40.2781 | 1.5603261 | (L32) |
| 37 | -2095.03788 | 1.0000 | | |
| 38 | 224.94312 | 41.9867 | 1.5603261 | (L33) |
| 39 | 1181.28198 | 1.0000 | | |
| 40 | 169.90399 | 30. 0146 | 1.5603261 | (L34) |
| 41* | 311.84318 | 34. 0057 | | |
| 42 | 3342.39918 | 11.4000 | 1.5603261 | (L35) |
| 43 | 105.65815 | 65.0304 | | |
| 44 | -174.98836 | 11.4000 | 1.5603261 | (L36) |
| 45* | 192.14769 | 26.0731 | | |
| 46* | -975.80968 | 34.9239 | 1.5603261 | (L37) |
| 47 | -209.61382 | 1.0000 | | |
| 48 | 269.61041 | 36.9061 | 1.5603261 | (L38) |

(continued)

(Optical Member Data)

| Surface No. | r | d | n | Optical Member |
|---|---|---|---|---|
| 49* | 1179.63479 | 15.2612 | | |
| 50 | 2880.70695 | 11.5239 | 1.5603261 | (L39) |
| 51* | 1268.63305 | 44.5100 | | |
| 52* | -1158.46665 | 33.5260 | 1.5603261 | (L310) |
| 53 | -305.65170 | 1.0000 | | |
| 54 | -688.74775 | 68.7373 | 1.5603261 | (L311) |
| 55 | -214.20371 | 1.0000 | | |
| 56 | ∞ | 1.0000 | | (AS) |
| 57 | 305.88059 | 60.0705 | 1.5603261 | (L312) |
| 58 | ∞ | 1.0000 | | |
| 59 | 204.35769 | 66.8588 | 1.5603261 | (L313) |
| 60* | 653.89394 | 1.0000 | | |
| 61 | 155.52236 | 47.4318 | 1.5603261 | (L314) |
| 62* | 937.19834 | 1.0000 | | |
| 63 | 75.94541 | 60.0423 | 1.5603261 | (L315:Lb) |
| 64 | ∞ | 4.0000 | 1.435876 | (Lm) |

(wafer surface)

(Aspherical Surface Data)

9th Surface: $\kappa=0$
$C_4=-6.40844\times10^{-8}$ $C_6=-5.61520\times10^{-12}$
$C_8=-3.34882\times10^{-16}$ $C_{10}=-7.06000\times10^{-21}$
$C_{12}=-2.05901\times10^{-25}$ $C_{14}=1.89216\times10^{-28}$
$C_{16}=-1.09057\times10^{-32}$

15th Surface: $\kappa=0$
$C_4=2.26863\times10^{-8}$ $C_6=-1.51954\times10^{-12}$
$C_8=-9.13872\times10^{-17}$ $C_{10}=4.18514\times10^{-21}$
$C_{12}=-3.54878\times10^{-25}$ $C_{14}=2.17808\times10^{-29}$
$C_{16}=-2.52193\times10^{-33}$

22nd Surface: $\kappa=0$
$C_4=1.41131\times10^{-8}$ $C_6=-1.59033\times10^{-13}$
$C_8=2.69389\times10^{-18}$ $C_{10}=-4.87841\times10^{-23}$
$C_{12}=5.00646\times10^{-21}$ $C_{14}=2.23100\times10^{-32}$
$C_{16}=-9.53921\times10^{-37}$

41st Surface: $\kappa=0$
$C_4=2.48058\times10^{-8}$ $C_6=2.03295\times10^{-14}$
$C_8=2.20595\times10^{-17}$ $C_{10}=-3.67285\times10^{-22}$
$C_{12}=1.11304\times10^{-25}$ $C_{14}=-6.42852\times10^{-30}$
$C_{16}=2.84451\times10^{-34}$

45th Surface: $\kappa=0$
$C_4=-5.32661\times10^{-8}$ $C_6=9.53947\times10^{-13}$
$C_8=-8.19130\times10^{-17}$ $C_{10}=9.53053\times10^{-21}$
$C_{12}=-7.72832\times10^{-25}$ $C_{14}=5.05308\times10^{-29}$
$C_{16}=-2.28684\times10^{-33}$

46th Surface: $\kappa=0$

(continued)

(Optical Member Data)

| Surface No. | r | d | n | Optical Member |
|---|---|---|---|---|

$C_4=1.56539\times10^{-8}$ $C_6=1.09724\times10^{-12}$
$C_8=-6.44186\times10^{-17}$ $C_{10}=-3.43849\times10^{-21}$
$C_{12}=2.86838\times10^{-25}$ $C_{14}=-1.57574\times10^{-29}$
$C_{16}=2.99230\times10^{-34}$
49th Surface: $\kappa=0$
$C_4=-8.43594\times10^{-9}$ $C_6=7.21625\times10^{-13}$
$C_8=7.27478\times10^{-17}$ $C_{10}=-3.93996\times10^{-21}$
$C_{12}=3.66629\times10^{-26}$ $C_{14}=2.38494\times10^{-31}$
$C_{16}=-3.73541\times10^{-36}$
51st Surface: $\kappa=0$
$C_4=4.62332\times10^{-8}$ $C_6=5.68461\times10^{-13}$
$C_8=-1.23738\times10^{-16}$ $C_{10}=2.86932\times10^{-21}$
$C_{12}=6.23168\times10^{-26}$ $C_{14}=-3.57421\times10^{-30}$
$C_{16}=5.22298\times10^{-35}$
52nd Surface: $\kappa=0$
$C_4=-3.86905\times10^{-8}$ $C_6=7.27527\times10^{-13}$
$C_8=-2.49269\times10^{-17}$ $C_{10}=7.87319\times10^{-22}$
$C_{12}=-2.62558\times10^{-26}$ $C_{14}=6.17032\times10^{-31}$
$C_{16}=-8.73564\times10^{-36}$
60th Surface: $\kappa=0$
$C_4=-3.82058\times10^{-8}$ $C_6=2.37223\times10^{-12}$
$C_8=-1.51016\times10^{-16}$ $C_{10}=7.40745\times10^{-21}$
$C_{12}=-2.27332\times10^{-25}$ $C_{14}=3.92794\times10^{-30}$
$C_{16}=-2.94937\times10^{-35}$
62nd Surface: $\kappa=0$
$C_4=4.03745\times10^{-8}$ $C_6=9.85095\times10^{-13}$
$C_8=5.63203\times10^{-18}$ $C_{10}=-3.83308\times10^{-21}$
$C_{12}=4.43636\times10^{-25}$ $C_{14}=-2.04297\times10^{-29}$
$C_{16}=4.51552\times10^{-34}$

(Condition Association Values)
$\beta12=0.4901$, $\beta1=0.4915$, $\beta3=0.2551$
$h=17.2mm$, $d1=33.34mm$, $d2=33.35mm$
(1) $d1/h=1.94$
(2) $d2/h=1.94$

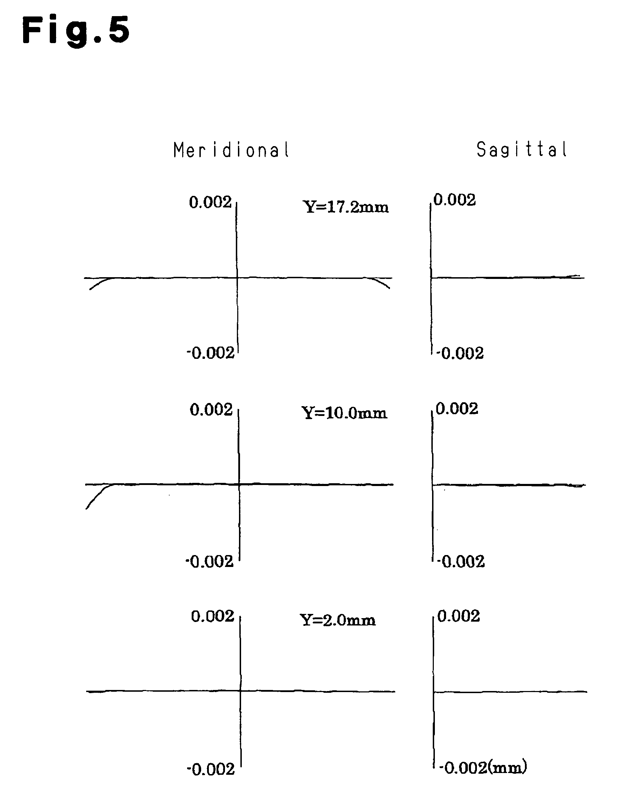

Fig. 5 is a chart showing transverse aberration in a projection optical system of the first example. In the aberration chart, Y represents the image height. As apparent from the aberration chart of Fig. 5, in the first example, aberration is corrected in a satisfactory manner for excimer laser light having a wavelength of 193.306 nm even though the image side numerical aperture (NA = 1.3) is extremely large and the exposure region ER (16.5 mm × 13 mm) is relatively large and has a rectangular form that is close to a square.

[Second Example]

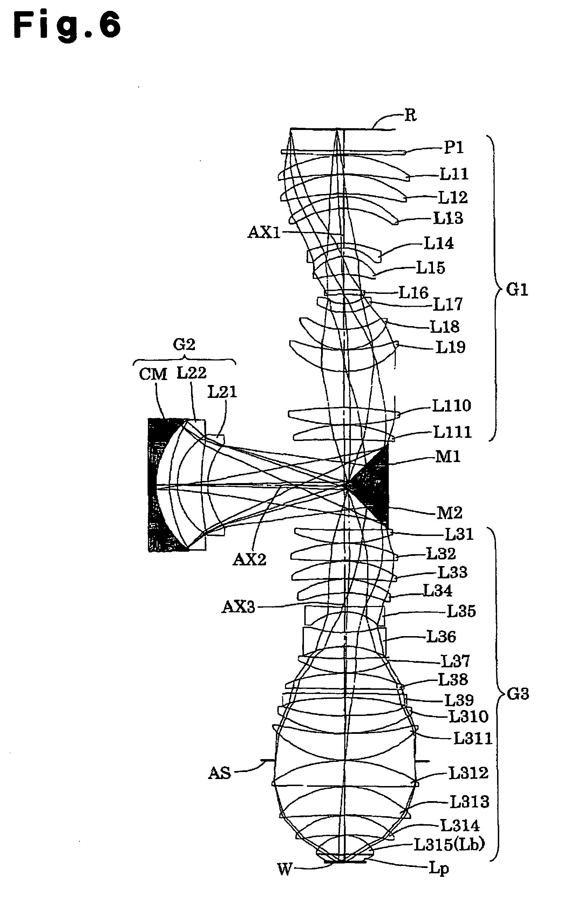

Fig. 6 is a diagram showing a lens structure of a projection optical system according to a second example of the present embodiment. Referring to Fig. 6, in the projection optical system PL of the second example, the first imaging system G1 includes, sequentially from the reticle side, a plane-parallel plate P1, a positive meniscus lens L11 having a convex surface facing toward the reticle side, a positive meniscus lens L12 having a convex surface facing toward the reticle side, a positive meniscus lens L13 having a convex surface facing toward the reticle side, a negative meniscus lens L14 having an aspherical convex surface facing toward the reticle side, a positive meniscus lens L15 having a convex surface facing toward the reticle side, a negative meniscus lens L16 having a convex surface facing toward the reticle side, a negative meniscus lens L17 having a concave surface facing toward the reticle side, a positive meniscus lens L18 having an aspherical concave surface facing toward the reticle side, a positive meniscus lens L19 having a concave surface facing toward the reticle side, a biconvex lens L110, and a positive meniscus lens L111 having an aspherical concave surface facing toward the wafer side.

Further, the second imaging system G2 includes, along the approach path of light sequentially from the incidence side of light, a negative meniscus lens L21 having a concave surface facing toward the incidence side, a negative meniscus lens L22 having a concave surface facing toward the incidence side, and a concave reflection mirror CM having a concave surface facing toward the incidence side. The third imaging system G3 includes, sequentially from the reticle side (i.e., incidence side of light), a positive meniscus lens L31 having a concave surface facing toward the reticle side, a biconvex lens L32, a positive meniscus lens L33 having a convex surface facing toward the reticle side, a positive meniscus lens L34 having an aspherical concave surface facing toward the wafer side, a biconcave lens L35, a biconcave lens L36 having an aspherical concave surface facing toward the wafer side, a positive meniscus lens L37 having an aspherical concave surface facing toward the reticle side, a positive lens L38 having an aspherical surface facing toward the wafer side, a negative meniscus lens L39 having an aspherical concave surface facing toward the wafer side, a positive meniscus lens 310 having an aspherical concave surface facing toward the reticle side, a positive meniscus lens 311 having a concave surface facing toward the reticle side, a variable aperture stop AS for varying the numerical aperture of the projection optical system PL, a planoconvex lens L312 having a planar surface facing toward the wafer side, a positive meniscus lens L313 having an aspherical concave surface facing toward the wafer side, a positive meniscus lens L314 having an aspherical concave surface facing toward the wafer side, a planoconvex lens L315 (boundary lens Lb) having a planar surface facing toward the wafer side, and a plane-parallel plate Lp.

In the same manner as in the first example, in the second example, pure water (Lm1, Lm2) having a refractive index of 1.435876 with respect to the used light (center wavelength λ = 193.306 nm) fills the optical path between the boundary lens Lb and the plane-parallel plate Lb and the optical path between the plane-parallel plate Lp and the wafer W. All light transmissive members including the boundary lens Lb and the plane-parallel plate Lp are made of silica having a refractive index of 1.5603261 with respect to the center wavelength of the used light. Table (2), which is shown next, lists values of data on the projection optical system PL of the second example.

Table (2)

(Main Data)

λ=193.306nm, β=1/8, NA=1.3

B=17.2mm, A=2mm, LX=16.5mm, LY=13mm

(Optical Member Data)

| Surface No. | r | d | n | Optical Member |
|---|---|---|---|---|
| (reticle surface) | | 50.00000 | | |
| 1 | ∞ | 8.00000 | 1.5603261 | (P1) |
| 2 | ∞ | 3.00000 | | |
| 3 | 258.31377 | 45.92612 | 1.5603261 | (L11) |
| 4 | 676.76098 | 1.00000 | | |
| 5 | 227.30894 | 45.68805 | 1.5603261 | (L12) |
| 6 | 503.00587 | 6.61323 | | |
| 7 | 167.89349 | 27.97385 | 1.5603261 | (L13) |
| 8 | 193.61124 | 83.06580 | | |
| 9* | 164.98601 | 11.40000 | 1.5603261 | (L14) |
| 10 | 92.23519 | 19.78603 | | |
| 11 | 81.28466 | 42.34265 | 1.5603261 | (L15) |
| 12 | 202.59935 | 35.96463 | | |
| 13 | 633.35035 | 11.40000 | 1.5603261 | (L16) |
| 14 | 418.54481 | 21.93939 | | |
| 15 | -75.60908 | 19.99420 | 1.5603261 | (L17) |
| 16 | -113.72534 | 41.76058 | | |
| 17* | -143.57296 | 48.80516 | 1.5603261 | (L18) |
| 18 | -108.10794 | 1.00000 | | |

(continued)

(Optical Member Data)

| Surface No. | r | d | n | Optical Member |
|---|---|---|---|---|
| 19 | -328.17749 | 52.70234 | 1.5603261 | (L19) |
| 20 | -154.76608 | 85.00314 | | |
| 21 | 706.06506 | 40.69561 | 1.5603261 | (L110) |
| 22 | -480.12718 | 1.00000 | | |
| 23 | 256.87815 | 35.74987 | 1.5603261 | (L111) |
| 24* | 3443.76334 | 110.00000 | | |
| 25 | ∞ | 316.08436 | | (M1) |
| 26 | -149.40615 | 15.00000 | 1.5603261 | (L21) |
| 27 | -586.54847 | 55.68083 | | |
| 28 | -138.27836 | 18.00000 | 1.5603261 | (L22) |
| 29 | -290.44321 | 30.36573 | | |
| 30 | -202.41659 | -30.36573 | | (CM) |
| 31 | -290.44321 | -18.00000 | 1.5603261 | (L22) |
| 32 | -138.27836 | -55.68083 | | |
| 33 | -586.54847 | -15.00000 | 1.5603261 | (L21) |
| 34 | -149.40615 | -315.08436 | | |
| 35 | ∞ | 105.00000 | | (M2) |
| 36 | -2382.89699 | 31.56384 | 1.5603261 | (L31) |
| 37 | -292.08925 | 1.00000 | | |
| 38 | 291.40422 | 42.07332 | 1.5603261 | (L32) |
| 39 | -3201.15450 | 1.00000 | | |
| 40 | 221.32921 | 42.84990 | 1.5603261 | (L33) |
| 41 | 1364.61978 | 1.00000 | | |
| 42 | 181.08523 | 33.24124 | 1.5603261 | (L34) |
| 43* | 284.15791 | 33.26802 | | |
| 44 | -1405.42871 | 11.40000 | 1.5603261 | (L35) |
| 45 | 107.70698 | 50.09719 | | |
| 46 | -246.11406 | 32.51983 | 1.5603261 | (L36) |
| 47* | 172.02555 | 28.91490 | | |
| 48* | -1519.15656 | 33.48441 | 1.5603261 | (L37) |
| 49 | -217.16540 | 1.00000 | | |
| 50 | 342.19484 | 36.82506 | 1.5603261 | (L38) |
| 51* | 8234.51910 | 11.55046 | | |
| 52 | 5847.55449 | 11.40000 | 1.5603261 | (L39) |
| 53* | 1336.07674 | 42.23646 | | |
| 54* | -854.26277 | 43.09043 | 1.5603261 | (L310) |
| 55 | -276.07064 | 1.00000 | | |
| 56 | -616.95484 | 62.05402 | 1.5603261 | (L311) |
| 57 | -224.02923 | 2.00000 | | |
| 58 | ∞ | 0.00000 | | (AS) |
| 59 | 307.74619 | 59.69102 | 1.5603261 | (L312) |
| 60 | ∞ | 1.00000 | | |
| 61 | 205.12005 | 66.39523 | 1.5603261 | (L313) |
| 62* | 695.60862 | 1.00000 | | |
| 63 | 154.44309 | 47.54638 | 1.5603261 | (L314) |
| 64* | 887.57922 | 1.00000 | | |
| 65 | 75.97999 | 44.98768 | 1.5603261 | (L315:Lb) |
| 66 | ∞ | 1.00000 | 1.435876 | (Lm2) |
| 67 | ∞ | 15.00000 | 1.5603261 | (Lp) |

(continued)

(Optical Member Data)

| Surface No. | r | d | n | Optical Member |
|---|---|---|---|---|
| 68 | ∞ | 3.00000 | 1.435876 | (Lm1) |

(wafer surface)

(Aspherical Surface Data)

9th Surface: $\kappa=0$
$C_4=-7.34450\times10^{-8}$ $C_6=-4.19630\times10^{-12}$
$C_8=-3.42294\times10^{-17}$ $C_{10}=6.48988\times10^{-21}$
$C_{12}=1.39194\times10^{-24}$ $C_{14}=-1.64446\times10^{-28}$
$C_{16}=5.35972\times10^{-33}$

17th Surface: $\kappa=0$
$C_4=2.33335\times10^{-8}$ $C_6=-1.37693\times10^{-12}$
$C_8=-4.54425\times10^{-17}$ $C_{10}=3.26479\times10^{-21}$
$C_{12}=3.66970\times10^{-25}$ $C_{14}=-5.09949\times10^{-29}$
$C_{16}=2.53840\times10^{-33}$

24th Surface: $\kappa=0$
$C_4=1.19018\times10^{-8}$ $C_6=-1.12159\times10^{-13}$
$C_{8=}1.73240\times10^{-18}$ $C_{10}=-2.24526\times10^{-23}$
$C_{12}=1.25965\times10^{-29}$ $C_{14}=1.53591\times10^{-32}$
$C_{16}=-3.82377\times10^{-37}$

43rd Surface: $\kappa=0$
$C_4=2.21239\times10^{-8}$ $C_6=1.04273\times10^{-13}$
$C_8=2.11135\times10^{-17}$ $C_{10}=-6.71090\times10^{-22}$
$C_{12}=2.06456\times10^{-25}$ $C_{14}=-1.49376\times10^{-29}$
$C_{16}=6.72189\times10^{-34}$

47th Surface: $\kappa=0$
$C_4=-7.90185\times10^{-8}$ $C_6=2.10846\times10^{-12}$
$C_8=-1.20601\times10^{-16}$ $C_{10}=1.22851\times10^{-20}$
$C_{12}=-7.75725\times10^{-25}$ $C_{14}=2.06221\times10^{-29}$
$C_{16}=-1.35949\times10^{-33}$

48th Surface: $\kappa=0$
$C_4=-1.14243\times10^{-8}$ $C_6=5.10196\times10^{-13}$
$C_8=-3.11126\times10^{-17}$ $C_{10}=3.17880\times10^{-22}$
$C_{12}=2.58675\times10^{-25}$ $C_{14}=-1.61455\times10^{-29}$
$C_{16}=-1.91033\times10^{-34}$

51st Surface: $\kappa=0$
$C_4=-1.73050\times10^{-8}$ $C_6=6.20543\times10^{-13}$
$C_8=8.08968\times10^{-17}$ $C_{10}=-3.75099\times10^{-21}$
$C_{12}=3.90201\times10^{-26}$ $C_{14}=-1.29175\times10^{-30}$
$C_{16}=3.11283\times10^{-35}$

53rd Surface: $\kappa=0$
$C_4=4.48734\times10^{-8}$ $C_6=2.23170\times10^{-13}$
$C_8=-1.13110\times10^{-16}$ $C_{10}=3.24099\times10^{-21}$
$C_{12}=2.95795\times10^{-26}$ $C_{14}=-2.74105\times10^{-30}$
$C_{16}=4.25390\times10^{-35}$

54th Surface: $\kappa=0$

(continued)

(Optical Member Data)

| Surface No. | r | d | n | Optical Member |
|---|---|---|---|---|

$C_4$=-2.97442$\times$10$^{-8}$ $C_6$=5.95262$\times$10$^{-13}$
C8=-1.64566$\times$10$^{-17}$ $C_{10}$=5.30613$\times$10$^{-22}$
$C_{12}$=-2.26165$\times$10$^{-26}$ $C_{14}$-6.24576$\times$10$^{-31}$
$C_{16}$=-1.07062$\times$10$^{-35}$

62nd Surface: $\kappa$=0
$C_4$=-3.51280$\times$10$^{-8}$ $C_6$=2.35985$\times$10$^{-12}$
$C_8$=-1.53713$\times$10$^{-16}$ $C_{10}$=7.40230$\times$10$^{-21}$
$C_{12}$=-2.21534$\times$10$^{-25}$ $C_{14}$=3.74193$\times$10$^{-30}$
$C_{16}$=-2.75763$\times$10$^{-35}$

64th Surface: $\kappa$=0
$C_4$=4.11314$\times$10$^{-8}$ $C_6$=4.55495$\times$10$^{-13}$
$C_8$=8.79081$\times$10$^{-17}$ $C_{10}$=-1.26060$\times$10$^{-20}$
$C_{12}$=1.05432$\times$10$^{-24}$ $C_{14}$=-4.61917$\times$10$^{-29}$
$C_{16}$=9.21569$\times$10$^{-34}$

(Condition Association Values)
$\beta$12=0.5008, $\beta$1=0.5055, $\beta$3=0.2496
h=17.2mm, d1=36.92mm, d2=39.22mm
(1) d1/h=2.15
(2) d2/h=2.28

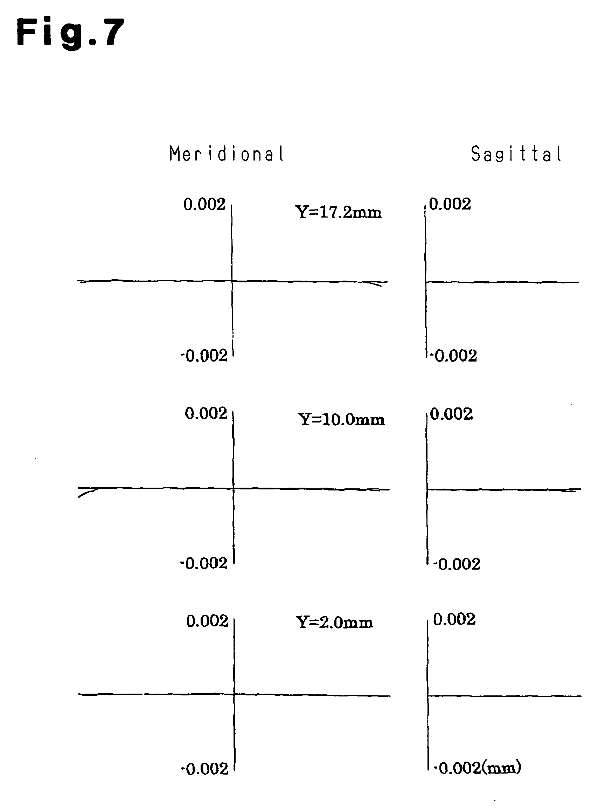

Fig. 7 is a chart showing transverse aberration in a projection optical system of the second example. In the aberration chart, Y represents the image height. As apparent from the aberration chart of Fig. 7, in the same manner as in the first example, in the second example, aberration is corrected in a satisfactory manner for excimer laser light having a wavelength of 193.306 nm even though the image side numerical aperture (NA = 1.3) is extremely large and the exposure region ER (16.5 mm $\times$ 13 mm) is relatively large and has a rectangular form that is close to a square.

In this manner, the projection optical system PL of the present embodiment employs a liquid immersion type imaging optical system. Thus, a large image side numerical aperture can be obtained while ensuring a relatively large effective imaging region. More specifically, in each example, for ArF excimer laser light having a center wavelength of 193.306 nm, a high image side numerical aperture of 1.3 and a rectangular effective imaging region of 16.5 mm $\times$ 13 mm can be obtained. For example, a circuit pattern can be batch-exposed in a rectangular exposure region ER of 16.5 mm $\times$ 13 mm with high accuracy and high throughput.

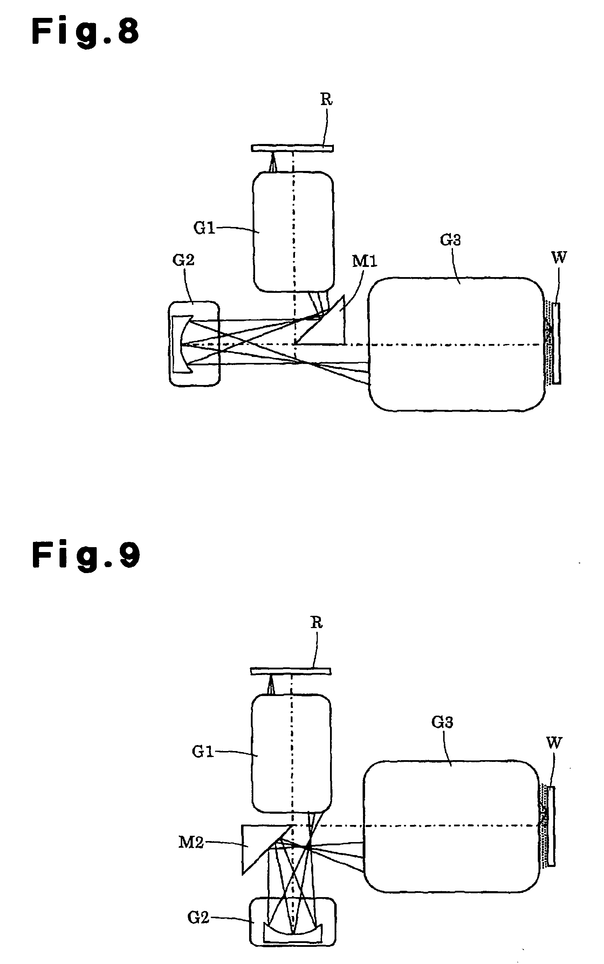

In the above-described embodiment, in the thrice imaging type catadioptric imaging optical system, deflecting mirrors (M1, M2) are arranged in the optical path from the first imaging system G1 to the second imaging system G2 and the optical path from the second imaging system G2 to the third imaging system G3. However, the present invention is not limited in such a manner. For example, as shown by the modification of Fig. 8, the present invention may be applied to a catadioptric imaging optical system in which the deflecting mirror M1 is arranged only in the optical path between the first imaging system G1 and the second imaging system G2. In this case, another deflecting mirror may be arranged in the first imaging system G1 or the third imaging system so that the reticle R and the wafer W are parallel to each other. Further, as shown in the modification of Fig. 9, the present invention may be applied to a catadioptric imaging optical system in which the deflecting mirror M2 is arranged only in the optical path between the second imaging system G2 and the third imaging system G3. In this case, another deflecting mirror may be arranged in the first imaging system G1 or the third imaging system so that the reticle R and the wafer W are parallel to each other.

Furthermore, in the above-described embodiment, the second imaging system G2 includes two negative lens and one concave reflection mirror. However, the present invention is not limited in such a manner, and various modifications are possible for the structure of the second imaging system G2. Further, in the above-described embodiment, the present invention is applied to a liquid immersion type catadioptric imaging optical system. However, the present invention is not limited in such a manner, and the present invention may also be applied to a dry type catadioptric imaging optical system that does not use immersion liquid at the image side.

In the above-described embodiment and modifications, instead of the mask (reticle), a pattern formation device may be used for forming a predetermined pattern based on predetermined electronic data. The employment of such a pattern formation device minimizes the influence a pattern plane has on the synchronizing accuracy even when the pattern plane is arranged in a horizontal direction. A digital micro-mirror device (DMD), which is driven based on, for example, predetermined electronic data, may be used as the pattern formation device. Exposure apparatuses using DMDs are described, for example, in Japanese Laid-Open Patent Publication No. 8-313842 and Japanese Laid-Open Patent Publication No. 2004-304135. Moreover, in addition to a non-light-emitting reflective type spatial light modulator such as a DMD, a transmissive type spatial light modulator may be used. Alternatively, a light-emitting type image display device may be used.

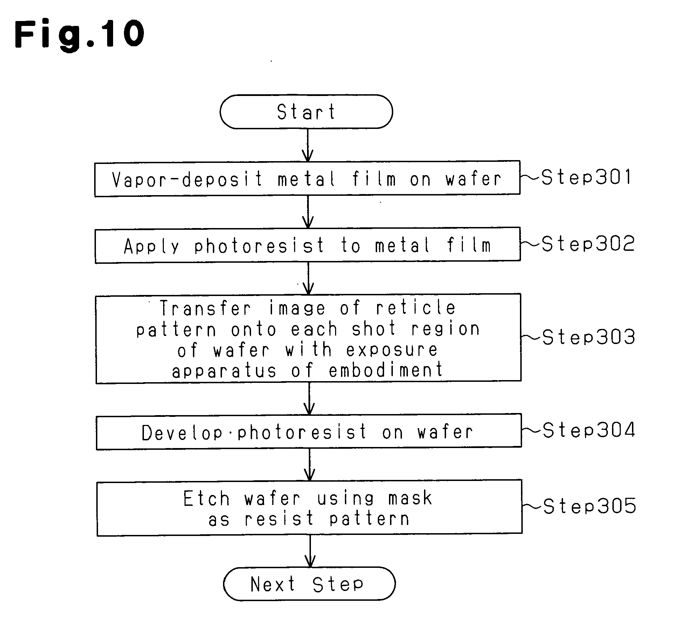

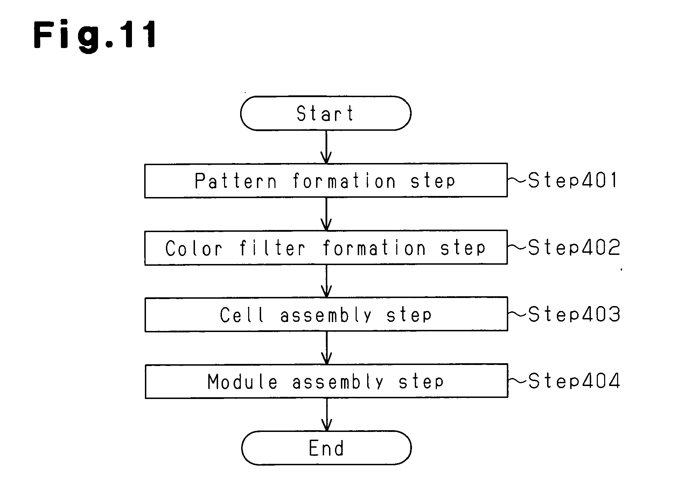

In the exposure apparatus of the above-described embodiment, a micro-device (semiconductor device, imaging device, liquid crystal display device, thin-film magnetic head, etc.) can be manufactured by illuminating a reticle (mask) with an illumination device (illumination process), and exposing a transfer pattern formed on a mask onto a photosensitive substrate using the projection optical system (exposure process). That is, in the exposure apparatus of the present embodiment, a semiconductor device serving as a micro-device can be obtained by forming a predetermined pattern on a wafer or the like serving as a photosensitive substrate in accordance with the flowchart of Fig. 10. Further, in the exposure apparatus of the present embodiment, a liquid crystal display device serving as a micro-device can be obtained by forming a predetermined pattern on a plate (glass substrate) in accordance with the flowchart of Fig. 11.

An ArF excimer laser light source is used in the above-described embodiment. However, the present invention is not limited in such a manner and other suitable light sources such as an $F_2$ laser light source may be used. If $F_2$ laser light is used as the exposure light, fluorine liquid such as fluorine oil and fluoropolyether (PFPE) that can transmit $F_2$ laser light is used as the liquid. Further, on the above-described embodiment, the present invention is applied to a projection optical system used in an exposure apparatus. However, the present invention is not limited in such a manner and may be applied to other suitable thrice imaging type catadioptric imaging optical systems.

**Claims**

1.    A catadioptric imaging optical system that forms a reduced image of a first plane on a second plane, the catadioptric imaging optical system comprising:

        a first imaging system including only refractive optical elements and which forms a first intermediate image based on light from the first plane;
        a second imaging system including at least one concave reflection mirror and which forms a second intermediate image based on light from the first intermediate image;
        a third imaging system including only refractive optical elements and which forms the reduced image of the first plane on the second plane based on light from the second intermediate image; and
        at least one deflecting mirror arranged in at least either one of an optical path extending from the first imaging system to the second imaging system and an optical path extending from the second imaging system to the third imaging system;

    wherein the first imaging system and the second imaging system provide a composite imaging magnification having an absolute value β12 of less than 0.55, and the third imaging system has an imaging magnification with an absolute value β3 of less than 0.35.

2.    The catadioptric imaging optical system according to claim 1, wherein the at least one deflecting mirror includes:

        a first deflecting mirror arranged in the optical path extending from the first imaging system to the second imaging system; and
        a second deflecting mirror arranged in the optical path extending from the second imaging system to the third imaging system;

    wherein the first imaging system has an imaging magnification with an absolute value β1 of less than 0.55.

3.    The catadioptric imaging optical system according to claim 2, wherein when a gas in an optical path of the catadioptric imaging optical system has a refractive index of 1, an optical path between the catadioptric imaging optical system and the second plane is filled with liquid having a refractive index that is greater than 1.3.

4.    The catadioptric imaging optical system according to any one of claims 1 to 3, wherein the catadioptric imaging optical system has an imaging magnification with an absolute value β of one-eighth.

5. The catadioptric imaging optical system according to any one of claims 1 to 4, wherein:

the catadioptric imaging optical system forms the reduced image in a rectangular region defined on the second plane separated from the optical axis; and
the rectangular region includes a long side having a length and a short side having a length, with the length of the short side to the length of the long side being a ratio of 0.5 or greater.

6. The catadioptric imaging optical system according to any one of claims 2 to 5, wherein:

the first intermediate image is formed in an optical path extending from the first deflecting mirror to the concave reflection mirror; and
the second intermediate image is formed in an optical path extending from the concave reflection mirror to the second deflecting mirror.

7. The catadioptric imaging optical system according to any one of claims 1 to 6, wherein the at least one deflecting mirror includes:

a first deflecting mirror arranged in the optical path extending from the first imaging system to the second imaging system;

wherein when d1 represents the distance between a paraxial image plane position of the first intermediate image and an intersecting point of an optical axis with a reflection surface of the first deflecting mirror or an extension of the reflection surface, and h represents maximum image height in the second plane, the condition of $1.4 < d1 < h$ is satisfied.

8. The catadioptric imaging optical system according to any one of claims 1 to 7, wherein the at least one deflecting mirror includes:

a second deflecting mirror arranged in the optical path extending from the second imaging system to the third imaging system;

wherein when d2 represents the distance between a paraxial image plane position of the second intermediate image and an intersecting point of the optical axis with a reflection surface of the second deflecting mirror or an extension of the reflection surface, and h represents maximum image height in the second plane, the condition of $1.4 < d2 < h$ is satisfied.

9. A catadioptric imaging optical system that forms a reduced image of a first plane on a second plane, the catadioptric imaging optical system comprising:

a dioptric first imaging system arranged in an optical path between the first plane and the second plane, with the first imaging system forming a first conjugation position optically conjugated with the first plane;
a second imaging system arranged in an optical path between the first imaging system and the second plane and including at least one concave reflection mirror, with the second imaging system forming a second conjugation position optically conjugated with the first conjugation position;
a dioptric third imaging system arranged in an optical path between the second imaging system and the second plane, with the second imaging system forming a third conjugation position optically conjugated with the second conjugation position;
at least one deflecting mirror arranged in at least either one of an optical path extending between the first imaging system and the second imaging system and an optical path extending between the second imaging system and the third imaging system;

wherein the first imaging system and the second imaging system provide a composite imaging magnification having an absolute value β12 of less than 0.55, and the third imaging system has an imaging magnification with an absolute value β3 of less than 0.35.

10. An exposure apparatus comprising:

the catadioptric imaging optical system according to any one of claims 1 to 9 which forms an image of a predetermined pattern on a photosensitive substrate set on the second plane based on light from the pattern, which is set on the first plane.

**11.** An exposure apparatus comprising:

a catadioptric imaging optical system that projects an image of a predetermined pattern set on a first plane onto a second plane based on light from the predetermined pattern;
a substrate stage which holds a photosensitive substrate positioned at the second plane; and
a control unit which controls movement of the substrate stage;

wherein the catadioptric imaging optical system includes a deflecting mirror and forms a position optically conjugated with the first plane in an optical path between the first plane and the second plane; and
the control unit controls the substrate stage in a static state when the image of the pattern is transferred to the photosensitive substrate.

**12.** A device manufacturing method comprising:

exposing the predetermined pattern onto the photosensitive substrate using the exposure apparatus according to claim 10 or 11;
developing the photosensitive substrate that has undergone the exposing.

# Fig.1

# Fig.2

# Fig.3(a)

# Fig.3(b)

EP 1 983 362 A1

# Fig.4

22

# Fig.5

Meridional                                    Sagittal

0.002          Y=17.2mm          0.002

-0.002                           -0.002

0.002          Y=10.0mm          0.002

-0.002                           -0.002

0.002          Y=2.0mm           0.002

-0.002                           -0.002(mm)

# Fig.6

# Fig.7

Meridional                                    Sagittal

0.002                Y=17.2mm              0.002

-0.002                                      -0.002


0.002                Y=10.0mm              0.002

-0.002                                      -0.002


0.002                Y=2.0mm               0.002

-0.002                                      -0.002(mm)

# Fig.8

# Fig.9

# Fig.10

```
                    ┌─────────────┐
                    │    Start    │
                    └──────┬──────┘
                           │
                           ▼
        ┌─────────────────────────────────────┐
        │ Vapor-deposit metal film on wafer   │─ Step301
        └──────────────────┬──────────────────┘
                           │
                           ▼
        ┌─────────────────────────────────────┐
        │  Apply photoresist to metal film    │─ Step302
        └──────────────────┬──────────────────┘
                           │
                           ▼
        ┌─────────────────────────────────────┐
        │      Transfer image of reticle      │
        │   pattern onto each shot region     │─ Step303
        │       of wafer with exposure        │
        │      apparatus of embodiment        │
        └──────────────────┬──────────────────┘
                           │
                           ▼
        ┌─────────────────────────────────────┐
        │    Develop photoresist on wafer     │─ Step304
        └──────────────────┬──────────────────┘
                           │
                           ▼
        ┌─────────────────────────────────────┐
        │       Etch wafer using mask         │─ Step305
        │         as resist pattern           │
        └──────────────────┬──────────────────┘
                           │
                           ▼
                    ┌─────────────┐
                    │  Next Step  │
                    └─────────────┘
```

# Fig.11

```
          ┌──────────────┐
          │    Start     │
          └──────┬───────┘
                 ↓
   ┌─────────────────────────────┐
   │  Pattern formation step     │ ~Step401
   └─────────────┬───────────────┘
                 ↓
   ┌─────────────────────────────┐
   │  Color filter formation step│ ~Step402
   └─────────────┬───────────────┘
                 ↓
   ┌─────────────────────────────┐
   │  Cell assembly step         │ ~Step403
   └─────────────┬───────────────┘
                 ↓
   ┌─────────────────────────────┐
   │  Module assembly step       │ ~Step404
   └─────────────┬───────────────┘
                 ↓
          ┌──────────────┐
          │     End      │
          └──────────────┘
```

## INTERNATIONAL SEARCH REPORT

International application No.

PCT/JP2007/051596

A. CLASSIFICATION OF SUBJECT MATTER
*G02B17/08*(2006.01)i, *G03F7/20*(2006.01)i, *H01L21/027*(2006.01)i

According to International Patent Classification (IPC) or to both national classification and IPC

B. FIELDS SEARCHED

Minimum documentation searched (classification system followed by classification symbols)
G02B17/08, G03F7/20, H01L21/027

Documentation searched other than minimum documentation to the extent that such documents are included in the fields searched
Jitsuyo Shinan Koho          1922-1996   Jitsuyo Shinan Toroku Koho    1996-2007
Kokai Jitsuyo Shinan Koho   1971-2007   Toroku Jitsuyo Shinan Koho    1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-536775 A  (Nikon Corp.),<br>02 December, 2005 (02.12.05),<br>Par. Nos. [0070], [0091], [0153]; Fig. 1<br>& US 2005/248856 A1    & EP 1532489 A<br>& WO 2004/19128 A2    & GB 311470 D<br>& CN 1668984 A       & TW 242691 B | 1-10,12 |
| Y | JP 2003-233009 A  (Nikon Corp.),<br>22 August, 2003 (22.08.03),<br>Claim 5; Par. No. [0046]; Fig. 5<br>(Family: none) | 1-10,12 |

☐ Further documents are listed in the continuation of Box C.          ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 25 April, 2007 (25.04.07) | 15 May, 2007 (15.05.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

## INTERNATIONAL SEARCH REPORT

International application No.

PCT/JP2007/051596

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:
    The inventions of claims 1-10, 12 relate to a particular catadioptric imaging system and an exposure device using the same.
    The invention of claim 11 relates to an exposure device having a particular control unit.

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1-10, 12

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 8062502 A
- WO 9949504 A
- JP 10303114 A

- JP 8313842 A
- JP 2004304135 A